# EUROPEAN PATENT APPLICATION

(11) **EP 1 432 122 A1**
(43) Date of publication of application: **23.06.2004**
(21) Application number: 02028644.9
(22) Date of filing: 20.12.2002
(51) Int. Cl.: H03G 3/30

(54) **Gain control unit for controlling two or more amplifiers**

(71) Applicant: Sony International (Europe) GmbH, 10785 Berlin (DE)
(72) Inventor: Wildhagen, Jens, Sony International (Europe) GmbH, 70327 Stuttgart (DE)
(74) Representative: Müller - Hoffmann & Partner

(57) **Abstract**

The invention relates to a gain control unit adapted for generating at least a first gain control signal for controlling a first amplifier's gain and a second gain control signal for controlling a second amplifier's gain. The first gain control signal is adapted for varying said first amplifier's gain in accordance with a fast time constant, and the second gain control signal is adapted for varying said second amplifier's gain in accordance with a slow time constant. In case of sudden changes of the input signal, the first amplifier quickly adjusts its gain to the new signal level, and overflow is avoided. The gain of the second amplifier is varied more slowly, in order to ensure a stable operation. A gain control unit according to the invention may be used for controlling the RF amplifier and the IF amplifier in a radio receiver.

## Description

The invention relates to a gain control unit, to a receiver and to a method for controlling a receiver's gain.

In a receiver, the received input signal covers a dynamic range of about 120 dB. A receiver usually comprises two or more amplifiers, and for handling said large dynamic range, it is desirable to vary the respective gain of said amplifiers in dependence on the signal strength of the received signal.

A gain control can be realized with a closed-loop control circuit. In case of sudden changes of the level of the input signal, the gain control circuit has to quickly adjust to the new input signal strength, because otherwise, overload or saturation will occur at some point within the signal path, and a distorted signal is obtained. Depending on the application for stable operation, a slow time constant of the automatic gain control circuit is often favourable.

A solution to this problem is described in the patent applications EP 01 127 362 and EP 01 122 979.6 filed by the application of the present application, which are herewith incorporated into the description of the present application. In these patent applications, it is described how the time constant of an automatic gain control unit (AGC) can be varied in dependence on the AGC's input level, whereby said time constant depends on the input level in a non-linear way. In case the level of the input signal gets too high, the time constant of the gain control unit is decreased, in order to accelerate the gain adjustment. Especially when the input signal causes a saturation of a subsequent A/D converter, the time constant of the automatic gain control is reduced.

It is an object of the invention to provide a gain control unit for controlling two or more amplifiers, whereby an overflow is avoided, and whereby a stable operation is ensured.

The object of the invention is solved by a gain control unit according to claim 1, by a receiver adapted for receiving a RF signal according to claim 15, and by a method for controlling a receiver's gain according to claim 18. Preferred embodiments thereof are respectively defined in the following dependent sub-claims. Computer program products according to the present invention are defined in claims 26 and 27.

The gain control unit according to the invention is adapted for generating at least a first gain control signal for controlling a first amplifier's gain and a second gain control signal for controlling a second amplifier's gain. The first gain control signal is adapted for varying said first amplifier's gain in accordance with a fast time constant, and said second gain control signal is adapted for varying said second amplifier's gain in accordance with a slow time constant.

The invention allows to combine the advantages of a slow time constant with the advantages of a fast time constant of the AGC. In case of a sudden increase or decrease of the signal strength of the input signal, the first amplifier's gain is quickly adjusted to the new level of the input signal. As a result, overflow within the signal path is avoided. Especially with respect to an A/D converter that is used for converting the received signal into a digital signal, it is made sure that saturation of said A/D converter does not occur, at least not for a long period of time. Any overflow causes severe distortions of the decoded signal, and therefore, the fast attack time of the first amplifier's gain control leads to an improved signal quality, particularily in cases when a fading signal is received.

The second amplifier is operated more slowly, it is operated with a slow time constant, and therefore, a stable operation both of the first and the second amplifier is ensured.

Preferably, said first amplifier's input signal is derived from said second amplifier's output signal. By slowly adapting the first amplifier's gain and more rapidly varying said second amplifier's gain, a stable operation is achieved.

According to a preferred embodiment of the invention, said first amplifier is an RF amplifier adapted for amplifying a RF signal. Further, said second amplifier is an IF amplifier adapted for amplifying an IF signal derived from the amplified RF signal. Additionally or alternatively, said second amplifier is adapted for amplifying a complex baseband signal derived by a complex mixer from the amplifyied RF signal. The RF amplifier's output signal is downconverted to an IF signal, which might be subjected to a filtering operation. By adjusting the RF amplifier's gain in accordance with the signal strength of the received RF signal, the dynamic range that has to be handled by the subsequent downconversion unit and by the filter is reduced. Because of the group delay caused by the filter, the control loop for adjusting the RF amplifier's gain has to be operated slowly. Otherwise, the RF amplifier's gain would not settly to a stable gain value.

According to a further preferred embodiment of the invention, said second gain control signal is adapted for varying said second amplifier's gain in a way that said first amplifier's gain is driven towards a medium range of gain values. The first amplifier's gain can be varied quickly. Because the attack time of the first amplifier is much faster than the attack time of the second amplifier, sudden changes of the received signal's strength have to handled by the first amplifier. In order to be able to react both to quick increases and decreases of the received signal's magnitude, the first amplifier is preferably operated in the medium gain range. Therefore, the second amplifier's gain is slowly driven to a level that brings back said first amplifier's gain to the desired range.

Preferably, said first gain control signal is derived from the first amplifier's output signal and a first reference value. The first gain control signal controls the gain of the first amplifier, and said amplifier can react fast to any changes. In order to avoid saturation of the A/D converter, the first amplifier's gain is continuously adjusted in a way that the first amplifier's output signal level settles to said first reference value.

Further preferably, said second gain control signal is derived from said first gain control signal and a second reference value. The second gain control signal is responsible for controlling the second amplifier's gain, whereby said gain may only be varied slowly. The aim is to slowly adjust the second amplifier's gain in a way that the first gain control signal is driven towards a gain value specified by said second reference value. Therefore, the first gain control signal is compared to the second reference value, and the second gain control signal is varied according to the deviation of said two values.

Preferably, in case said first amplifier's output signal, or a signal derived therefrom, exceeds a predefined threshold, either said fast time constant, or said slow time constant, or both said fast and said slow time constant are reduced. Said threshold might for example indicate an overflow of the A/D converter. An overflow causes signal distortions. Therefore, the gain has to be reduced very quickly, whereby the gain adjustment is accelerated by reducing the time constants. Additionally or alternatively, in case said second amplifier's output signal exceeds a predefined threshold, the gain of the second amplifier is reduced, i.e. the second amplifier's gain can be reduced when an overload occurs in the components, e.g. mixer, IF filter, following the second amplifier.

According to a preferred embodiment of the invention, the gain control unit comprises a first control loop for generating said first gain control signal, and a second control loop for generating said second gain control signal. Thus, the time constant of the first gain control signal and the time constant of the second gain control signal can be set individually.

Preferably, said first control loop comprises a first subtracter for determining a first difference between said first amplifier's output signal, or a signal derived therefrom, and a first reference value. The first difference indicates how much the first amplifier's output signal deviates from the desired reference value.

Preferably, said first control loop comprises a first scaling unit for scaling said first difference in accordance with said fast time constant, in order to obtain a first scaled difference, and a first integrator for deriving said first gain control signal from said first scaled difference. Said first difference determines whether the first amplifier's gain has to be increased or decreased. The gain adjustment can be accelerated by multiplying said first difference with a large factor. Therefore, the magnitude of said fast time constant is comparatively large. Said scaled difference is summed up by an integrator, and thus, the first gain control signal is obtained.

Further preferably, said second control loop comprises a second subtracter for determining a second difference between said first gain control signal and a second reference value. The behaviour of the second control loop depends on the first gain control signal. The second difference indicates how much the first gain control signal deviates from an ideal value specified by the second reference value. The second gain control signal is then adjusted in a way that said second difference is reduced.

Further preferably, said second control loop comprises a second scaling unit for scaling said second difference in accordance with said slow time constant, in order to obtain a second scaled difference, and a second integrator for deriving said second gain control signal from said second scaled difference.

Preferably, said medium range of gain values is defined by said second reference value.

According to a preferred embodiment of the invention, at least one of said first integrator and said second integrator comprises an adder and a register for storing a former gain control value. In the adder, the respective scaled difference is added to the former gain control value, and a modified gain control value is obtained.

According to the invention, the receiver adapted for receiving an RF signal comprising a RF amplifier for amplifying said RF signal, a downconversion unit for converting an amplified RF signal or a signal derived therefrom, into an IF signal, an IF amplifier for amplifying said IF signal, and a gain control unit according to anyone of claims 1 to 14, whereby said RF amplifier's gain in controlled by said second gain control signal, and whereby said IF amplifier's gain is controlled by said first gain control signal. The RF amplifier's gain is varied rather slowly, while the IF amplifier's gain can instantaneously react to any changes of the input signal's strength. Signal distortions are avoided, and a stable operation of the two amplifiers is possible.

According to a preferred embodiment of the invention, the receiver comprises an A/D converter for converting the IF amplifier's output signal, or a signal derived therefrom, into a digital signal. Further signal processing can e.g. be implemented by means of a processor, preferably by means of a digital signal processor (DSP). Also the gain control unit can be implemented as a series of signal processing steps.

Further preferably, the receiver comprises D/A converters for converting said first gain control signal and said second gain control signal into analogue gain control signals. The amplifiers might for example be realized as VCAs (Voltage Controlled Amplifiers). In this case, an analogue gain control signal is required.

These and further aspects will be elucidated in more detail taking into account the following remarks.

The invention is related to a digital controlled AGC to control the input level of an IF ADC. The IF ADC samples an IF broadcast signal. The digital AGC controls two VCAs. Both VCAs are controlled dependent on each other with a different time constant.

In a digital receiver, a digital controlled AGC needs to avoid the saturation of the IF ADC. A saturation of the IF ADC leads to strong distortions in the demodulated analogue or digital signal. Therefore, AGC have often a nonlinear character with a different attack, hold and decay time constant or a amplitude dependent time constant selection as described in the above mentioned patent application. Usually, the AGC reacts very fast to large gain increases to avoid an IF ADC saturation.

An AGC with a fast attack time requires low delay in the AGC loop. An AGC with a fast attack time and a long delay in the AGC loop becomes instable.

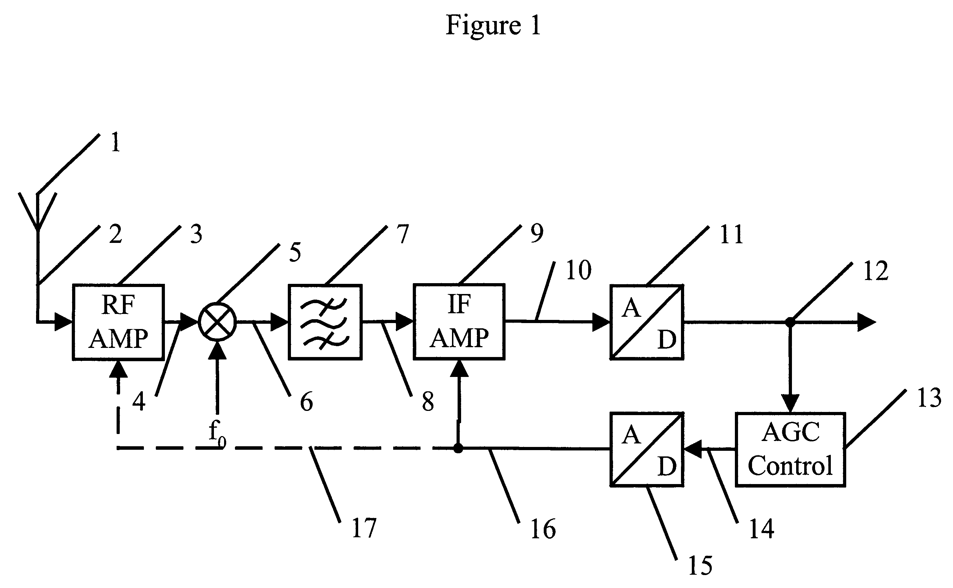

Figure 1 without line 17 depicts a block diagram of a receiver with an AGC loop with low delay time. Therefore, this AGC loop is able to react fast to gain changes. The AGC is stable even for fast time constants. However, the receiver has the disadvantage that the complete dynamic range of the receiver is controlled after the Mixer and the IF filter. This is in a practical implementation of a radio receiver impossible, since the Mixer and the IF filter can not handle the high dynamic range. Therefore, usually the RF amplifier and the IF amplifier are controlled by the AGC.

Sometimes, the AGC control signal from the AGC control block is divided into two different control signals for the RF amplifier and the IF amplifier. For example, in case the AGC has an overall dynamic range of 0 to +100dB, the RF amplifier has a gain from 0 to +50dB and the IF amplifier changes the AGC gain in the range from +50dB to +100dB.

This control solves the problem that the mixer and the IF filter can not handle the high dynamic range of the input signal, since the dynamic range at the Mixer and the IF filter is reduced. However, both amplifiers are controlled by the same time constant. Since the AGC loop from AGC control to RF amp, Mixer, IF filter has a long delay, i.e. the group delay of the IF filter in case of narrowband signals like AM signals, the AGC loop is instable for fast AGC time constants. The AGC loop is only stable for large AGC time constants. This means, that the AGC is not able to react to quick field strength changes and that in case of quick fieldstrength changes the IF ADC is in a saturation state. This means, that the reception is strongly disturbed.

A basic idea of this invention is to split the AGC control signal into a signal with a slow time constant and a signal with a fast time constant. The component with the slow time constant controls the RF amplifier and the component with the quick time constant controls the IF amplifier. Thus, the AGC allows to react quickly to fast fieldstrength changes. In the same time, the RF AGC loop has a slow time constant, so that the RF AGC loop is stable. In order to be able to react to quick fieldstrength increases and decreases, the IF amplifier operates in the "middle gain range".

One major advantage of the present invention is the possibility of fast tracking to field strength changes in combination with a stable AGC loop. This results in minimized distortions in the audio signal in a fading channel.

Often, the RF amplifier output has an overload detector, that decreases the RF gain in case that an overload occurs.

In the following, the invention will be described in more detail taking reference to the accompanying figures on the basis of preferred embodiments of the invention.
- **Fig. 1**: is a receiver with a gain control unit that controls both the RF amplifier's gain and the IF amplifier's gain;
- **Fig. 2**: is a gain control unit that generates a first gain control signal with a fast time constant and a second gain control signal with a slow time constant;
- **Fig. 3A**: is a first example for an A/D converter input signal, whereby at t ≅ 4 msec, the signal amplitude is increased by 20 dB;
- **Fig. 3B**: is the IF amplifier's gain control signal that corresponds to the input signal shown in Fig. 3A;
- **Fig. 3C**: is the RF amplifier's gain control signal that corresponds to the input signal shown in Fig. 3A;
- **Fig. 4A**: is a second example for an A/D converter input signal, whereby at t ≅ 5 msec, the signal amplitude is increased by 30 dB;
- **Fig. 4B**: is the IF amplifier's gain control signal that corresponds to the input signal shown in Fig. 4A; and
- **Fig. 4C**: is the RF amplifier's gain control signal that corresponds to the input signal shown in Fig. 4A.

Fig. 1 shows a receiver, preferably a radio receiver, with an automatic gain control unit. A RF signal 2 received via an antenna 1 is provided to a RF amplifier 3. An amplified RF signal 4 is downconverted, by an mixer 5, to an intermediate frequency range. The mixer 5 multiplies the amplified RF signal 4 with a signal of constant frequency f₀. The downconverted signal 6 is provided to an intermediate frequency filter 7, and the filtered signal 8 is amplified by an IF amplifier 9. The analogue IF signal 10 is converted, by an A/D converter 11, to a digital IF signal 12. The digital IF signal 12 serves as a starting point for further signal processing and signal decoding. Of course, the invention can also be used for direct downconversion architectures. In this case, both amplifiers for IfQ of the AGC's input signals are controlled by the same IF gain. Besides that, the digital signal 12 is provided to an automatic gain control unit 13, and there, the signal strength of the digital IF signal 12 is compared to a reference magnitude. The automatic gain control unit 13 generates a digital gain control signal 14 that is converted, by a D/A converter 15, into a gain control signal 16 for the IF amplifier 9. The gain of the IF amplifier 9 is varied in accordance with the gain control signal 16. The AGC loop that has been described so far is capable of quickly adjusting to a change of the received signal's magnitude. Besides that, an AGC loop in which the IF amplifier's gain is controlled is stable even in case of fast gain adjustments.

However, when the receiver's gain is only controlled on the part of the IF amplifier 9, both the mixer 5 and the intermediate frequency filter 7 have to cope with the high dynamic range of the received RF signal 2. For this reason, an implementation where the receiver's gain is only controlled on part of the IF amplifier 9 is not favourable. For this reason, the gain of the RF amplifier 3 has to be adjusted to the actual magnitude of the received RF signal 2 as well. In case of a weak RF signal 2, the gain of the RF amplifier 3 is increased, and in case of a strong RF signal 2, the gain of said amplifier is reduced. By doing this, the dynamic range of the amplified RF signal 4 is reduced.

The gain of the RF amplifier is controlled by the gain control signal 17. For example, the gain control signal 16 might as well be provided, as a gain control signal 17, to the RF amplifier 3. However, in this case, both the RF amplifier 3 and the IF amplifier 9 would be controlled by gain control signals having one common predefined time constant. Due to the rather long delay caused by the intermediate frequency filter's group delay, the AGC loop for controlling the RF amplifier's gain comprises a rather long delay, and therefore, this AGC loop becomes instable in case of a fast time constant. The AGC loop for the RF amplifier 3 is only stable in case of a slow time constant. This implies that in case of fast changes of the signal strength, an overflow of the A/D converter 11 is likely to occur. Overflow of the A/D converter 11 should be avoided in any case, though, because it leads to a strongly distorted signal.

According to the invention, an AGC control signal with a slow time constant and an AGC control signal with a fast time constant is provided, whereby the gain control signal with the slow time constant controls the RF amplifier 3, and whereby the gain control signal with the fast time constant controls the IF amplifier 9.

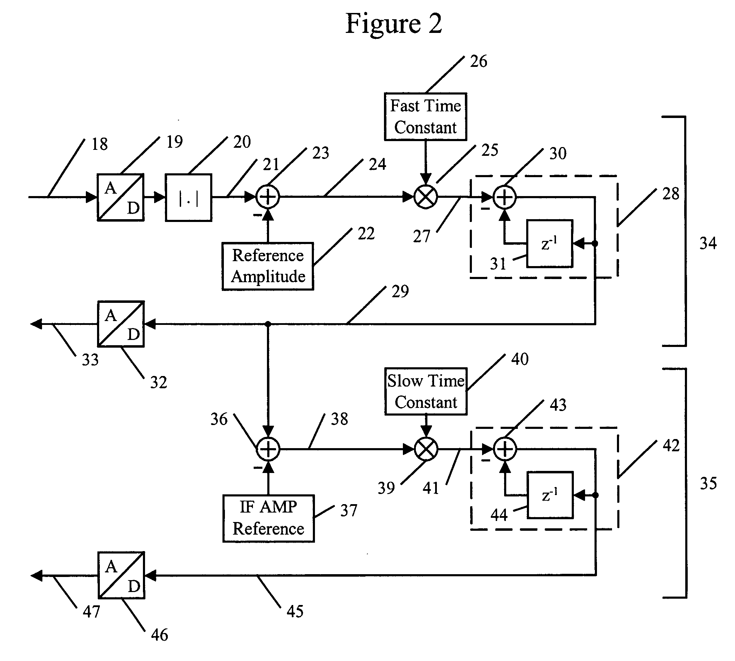

In Fig. 2, the circuit used for generating said two gain control signals is shown. The analogue IF signal 18 obtained at the output of the IF amplifier 9 is provided to the A/D converter 19. In case the digital values obtained at the output of the A/D converter 19 have a negative sign, the absolute value determination unit 20 changes said negative sign into a positive sign. From the signal amplitude 21 obtained at the output of the absolute value determination unit 20, a reference amplitude 22 is subtracted, and at the output of the subtracter 23, the variance 24 of the signal amplitude with respect to the reference amplitude is obtained. The variance 24 indicates how much the signal amplitude 21 deviates from the desired signal amplitude as defined by the reference amplitude 22. Therefore, the variance 24 is the starting point for determining the gain control signals for the IF amplifier 9 and for the RF amplifier 3.

For controlling the IF amplifier's gain, a gain control signal with a fast time constant is required. In order to generate such a signal, the variance 24 is forwarded to a multiplier 25, and there, it is multiplied with the fast time constant 26. The fast time constant 26 is set to a rather large value, and therefore, the scaled variance 27 obtained at the multiplier's output is rather large as well. The scaled variance 27 is converted, by the integrator 28, into the gain control signal 29 for the IF amplifier. The integrator 28 comprises an adder 30 and a register 31 for storing the former gain control value of the IF amplifier. The adder 30 adds the scaled variance 27 to the former gain control value. As a result of the addition, a new gain control value for the IF amplifier is obtained.

The receiver's gain is indirectly proportional to the respective gain control value. An increase of the gain control value will therefore lead to a reduction of the receiver's gain. The new gain control value is stored to the register 31. Besides that, the new gain control value is forwarded, as a gain control signal 29, to the D/A converter 32, and there, the digital gain control signal 29 is converted into an analogue gain control signal 33. Said signal is used for controlling the gain of the IF amplifier 9. Because of the fast time constant 26, the gain control signal 29 adjusts rather quickly to any change of the analogue IF signal 18, and the attack time of the control loop 34 for the IF amplifier is rather fast. Because of the quick reaction within the control loop 34, any saturation of the A/D converter 11 can be avoided.

Next, the control loop 35 for the RF amplifier 3 will be discussed. The aim is to vary the RF amplifier's gain in a way that the gain of the IF amplifier 9 is kept in a predefined medium range as long as possible. In the subtracter 36, a reference value 37 that corresponds to the desired medium range of the gain control signal 29 is subtracted from said gain control signal 29. At the output of the subtracter 36, the variance 38 of the gain control signal with respect to said reference value is obtained. In the multiplier 39, the variance 38 is multiplied with a slow time constant 40, and the scaled variance 41 is obtained. By setting the slow time constant 40 to a rather low value, the scaled variance 41 assumes a rather low value as well, and this leads to a rather slow adjustment of the RF amplifier's gain. The scaled variance 41 is provided to the integrator 42, which comprises an adder 43 and a register 44 for storing the former gain control value of the RF amplifier. In the adder 43, the scaled variance 41 is added to said former gain control value of the RF amplifier, and as a result, a new gain control value is obtained. Said new gain control value is provided, as a digital gain control signal 45, to the D/A converter 46. At the output of the D/A converter 46, an analogue gain control signal 47 for the RF amplifier 3 is obtained, and said analogue gain control signal 47 is used for controlling the gain of the RF amplifier 3. Whenever the gain control signal 29 assumes a value above the predetermined reference value 37, the scaled variance 41 assumes a positive value. This leads to a continuous slow increase of the analogue gain control signal 47. The RF amplifier's gain, which is indirectly proportional to the analogue gain control signal 47, is slowly reduced, and therefore, the magnitude of the analogue IF signal 18 is decreased. Correspondingly, the gain control signal 29 is decreased until it approaches the reference value 37.

The control loop 35 slowly adjusts the RF amplifier's gain in a way that the IF amplifier's gain is kept within a medium range. Because of the rather low magnitude of the slow time constant 40, it is made sure that fast variations of the RF amplifier's gain are avoided, because such fast variations could cause an instability within the control loop 35.

Typically, the dynamic range of the received RF signal is in the order of 120 dB. For an example, the AGC might have an overall dynamic range from 0 dB to +100 dB, whereby the RF amplifier's gain might range from 0 dB to +50 dB, whereby the IF amplifier's gain might range from 0 dB to +50 dB, and whereby the total AGC gain is obtained by adding the respective gain of the RF amplifier and the IF amplifier. In the following, a table comprising three columns is shown, whereby the first column corresponds to the AGC's total gain, whereby the second column corresponds to the RF amplifier's gain, and whereby the third column contains the IF amplifier's gain:

| **AGC's Total Gain** | **RF Amplifier's Gain** | **IF Amplifier's Gain** |
|---|---|---|
| 10 | 0 | 10 |
| 20 | 0 | 20 |
| 30 | 5 | 25 |
| 40 | 15 | 25 |
| 50 | 25 | 25 |
| 60 | 35 | 25 |
| 70 | 45 | 25 |
| 80 | 50 | 30 |
| 90 | 50 | 40 |
| 100 | 50 | 50 |

From this table, it can be seen that the IF amplifier's gain is kept close to 25 dB for a wide range of possible input signal strengths. According to the invention, the RF amplifier's gain is slowly varied in a way that the IF amplifier's gain is kept in a medium range around 25 dB. In case of a sudden change of the received RF signal's strength, this sudden change can be compensated by instantaneously adjusting the IF amplifier's gain. When the IF amplifier operates in the medium gain range, it can react both to quick field strength increases and decreases. In case the AGC's total gain that is close to 0 dB, the IF amplifier's gain has to be reduced to a value outside of the medium range, though. Accordingly, when the AGC's approaches 100 dB, the IF amplifier's gain has to be set to a value close to 50 dB.

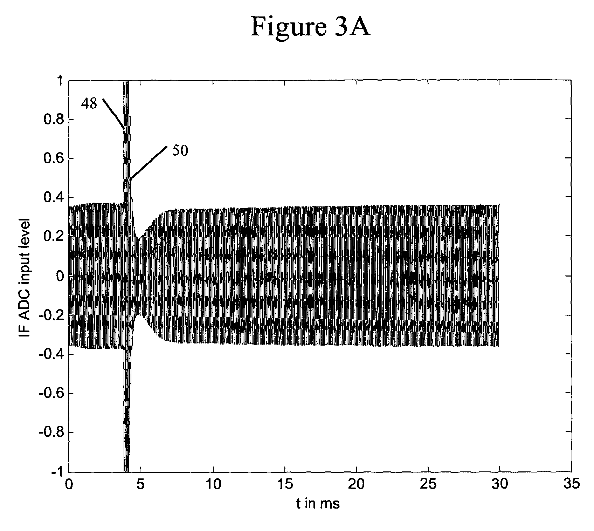

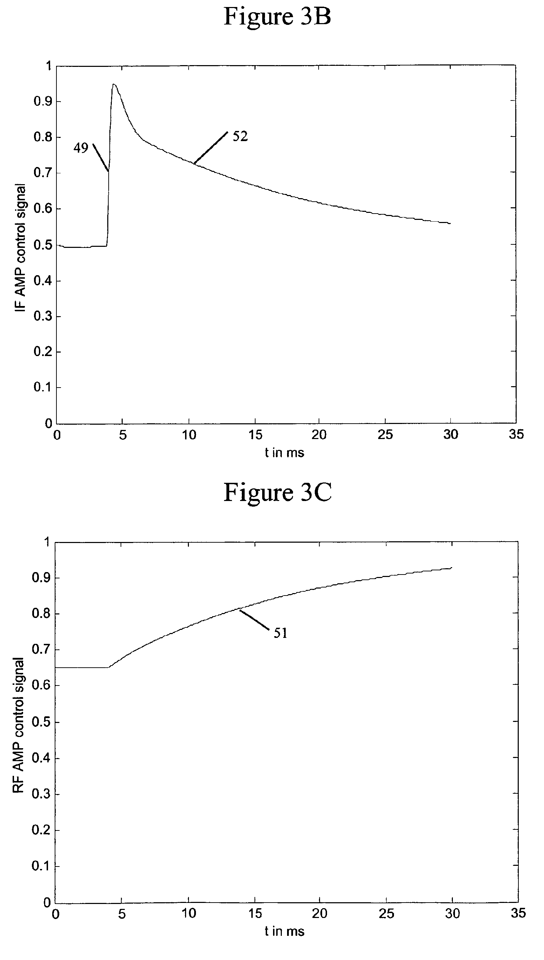

In Fig. 3A, a first example of an IF ADC input signal is shown as a function of time. The IF ADC input signal is a sinusoidal signal. At the time t ≅ 4 msec, the amplitude of the IF input signal is increased by 20 dB. Fig. 3B shows the time dependence of the IF amplifier's gain control signal, while Fig. 3C depicts the RF amplifier's gain control signal as a function of time. Due to the sudden increase 48 of the input signal's amplitude, the control loop 34 instantaneously increases (49) the IF amplifier's gain control signal, in order to reduce the IF amplifier's gain. As a consequence, the input level of the A/D converter 19 is reduced (50), and saturation of the A/D converter 19 is avoided. Due to the sudden gain adjustment of the IF amplifier's gain, the IF amplifier's gain is not within the medium range of gain values any more. The value of the gain control signal 29 differs considerably from the reference value 37, and for this reason, the variance 38 assumes a rather large value. Because of the slow time constant 40, the large magnitude of the variance 38 leads to a rather slow increase 51 of the RF amplifier's gain control signal 45. The increase 51 of said gain control signal is shown in Fig. 3C. After the amplitude of the IF input signal has been increased by 20 dB at the time t ≅ 4 msec, the signal amplitude of said IF input signal remains constant. For this reason, the continuous increase 51 of the RF amplifier's gain control signal causes a corresponding decrease 52 of the IF amplifier's gain control signal shown in Fig. 3B. The RF amplifier's gain is continuously decreased, while the IF amplifier's gain is moved towards the medium gain range.

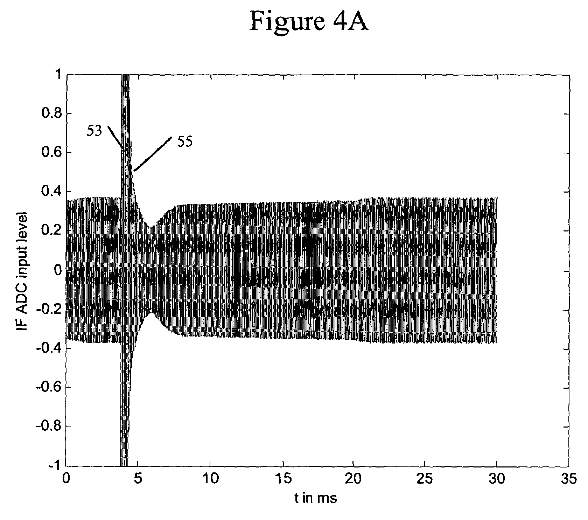

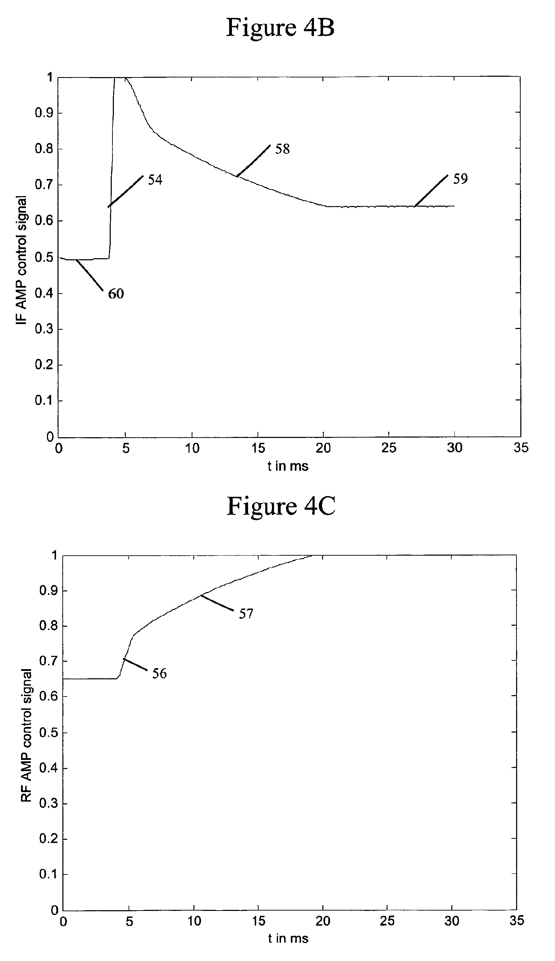

In the Fig. 4A, 4B and 4C, a second example of the AGC's response to a sudden change of the input signal's amplitude is shown. Fig. 4A shows the input level of the A/D converter 19 as a function of time. The IF ADC input level is increased, at the time t ≅ 5 msec, by 30 dB. This tremendous increase 53 of the input signal level causes a saturation of the A/D converter 19. The AGC has to react extremely fast to reduce the distortions caused by the A/D converter's overflow. By instantaneously increasing (54) the IF amplifier's gain control signal 29, the IF amplifier's gain is immediately reduced.

In the above-mentioned patent applications applications EP 01 127 362 and EP 01 122 979.6, it is described that the time constant of an AGC is varied in dependence on the AGC's input level, whereby said time constant depends on the input level in a non-linear way. Said two patent applications are herewith incorporated into the description of the present application. Especially in case the amplifier's output level causes a saturation of the subsequent A/D converter (or in case the A/D converter gets close to saturation), the time constant of the automatic gain control is reduced, and the re-adjustment of the gain is accelerated. This inventive concept can be combined with the subject matter of the present invention. In case an overflow of the A/D converter 19 occurs, the fast time constant 26 of the IF amplifier's control circuit 34 might be reduced further, or the slow time constant 40 of the RF amplifier's control circuit 35 might be reduced, or both of said time constants might be reduced in order to quickly reduce the corresponding amplifier's gain.

Therefore, the increase 54 of the IF amplifier's gain control signal might be accelerated by an additional reduction of the fast time constant 26. The increase 54 causes a reduction of the IF amplifier's gain, and as a result, the A/D converter's input level is decreased (55). The magnitude of the IF amplifier's gain control signal 29 now is much higher than the corresponding reference value 37, and therefore, the RF amplifier's gain control signal, which is shown in Fig. 4C, starts to increase continuously, whereby said increase is controlled by the slow time constant 40. According to the concept described above, said slow time constant 40 is reduced when saturation occurs. During the time interval 56, the RF amplifier's gain is reduced quickly. As soon as the A/D converter 19 is not saturated anymore, the slow time constant 40 reassumes its original value, and the RF amplifier's gain control signal rises more slowly (57). The AGC's total gain remains constant, and therefore, a corresponding decline 58 of the IF amplifier's gain control signal can be observed in Fig. 4B. The IF amplifier's gain control signal is decreased until it approaches the medium range, but due to the rather large increase of 30 dB, the IF amplifier's gain control signal remains at a final level 59 that is above the original level 60, and therefore, the IF amplifier's gain is set to a value below said medium gain range.

### List of Reference Symbols

- **1**: antenna
- **2**: RF signal
- **3**: RF amplifier
- **4**: amplified RF signal
- **5**: mixer
- **6**: downconverted signal
- **7**: intermediate frequency filter
- **8**: filtered signal
- **9**: IF amplifier
- **10**: analogue IF signal
- **11**: A/D converter
- **12**: digital IF signal
- **13**: automatic gain control unit
- **14**: digital gain control signal
- **15**: D/A converter
- **16**: gain control signal for IF amplifier
- **17**: gain control signal for RF amplifier
- **18**: analogue IF signal
- **19**: A/D converter
- **20**: absolute value determination unit
- **21**: signal amplitude
- **22**: reference amplitude
- **23**: subtracter
- **24**: variance
- **25**: multiplier
- **26**: fast time constant
- **27**: scaled variance
- **28**: integrator
- **29**: gain control signal (for IF amplifier)
- **30**: adder
- **31**: register
- **32**: D/A converter
- **33**: analogue gain control signal
- **34**: control loop (for the IF amplifier)
- **35**: control loop (for the RF amplifier)
- **36**: subtracter
- **37**: reference value
- **38**: variance
- **39**: multiplier
- **40**: slow time constant
- **41**: scaled variance
- **42**: integrator
- **43**: adder
- **44**: register
- **45**: digital gain control signal
- **46**: D/A converter
- **47**: analogue gain control signal
- **48**: sudden increase of input signal's amplitude
- **49**: increase of IF amplifier's gain control signal
- **50**: reduction of input level of A/D converter
- **51**: slow increase of RF amplifier's gain control signal
- **52**: decrease of IF amplifier's gain control signal
- **53**: increase of the input signal level
- **54**: increase of the IF amplifier's gain control signal
- **55**: decrease of A/D converter's input level
- **56**: time interval of quick reduction of RF amplifier's gain
- **57**: slow rise of RF amplifier's gain control signal
- **58**: decline of IF amplifier's gain control signal
- **59**: final level of IF amplifier's gain control signal
- **60**: original level of IF amplifier's gain control signal

## Claims

1. Gain control unit,
which is adapted for generating at least a first gain control signal (29) for controlling a first amplifier's gain and a second gain control signal (45) for controlling a second amplifier's gain,
**characterized in that**
- said first gain control signal (29) is adapted for varying said first amplifier's gain in accordance with a comparable fast or low time constant (26) and
- said second gain control signal (45) is adapted for varying said second amplifier's gain in accordance with a comparable slow or high time constant (40).

2. Gain control unit according to claim 1,
**characterized in that**
said first amplifier's input signal (8) is derived from said second amplifier's output signal (4).

3. Gain control unit according to claim 1 or 2,
**characterized in that**
- said first amplifier is an RF amplifier (3) adapted for amplifying a RF signal (2), and
- said second amplifier is an IF amplifier (9) adapted for amplifying an IF signal (8) derived from the amplified RF signal (4) and/or said second amplifier adapted for amplifying a complex baseband signal derived by a complex mixer from the amplifyied RF signal (4).

4. Gain control unit according to any one of the preceding claims,
**characterized in that**
said second gain control signal (45) is adapted for varying said second amplifier's gain in a way that said first amplifier's gain is moved/driven towards a medium range of gain values.

5. Gain control unit according to any one of the preceding claims,
**characterized in that**
said first gain control signal (29) is derived from the first amplifier's output signal (18) and a first reference value (22).

6. Gain control unit according to any one of the preceding claims,
**characterized in that**
said second gain control signal (45) is derived from said first gain control signal (29) and a second reference value (37).

7. Gain control unit according to any one of the preceding claims,
**characterized in that**
- in case said first amplifier's output signal (18), or a signal derived therefrom, exceeds a predefined threshold, either said fast time constant (26), or said slow time constant (40), or both said fast and said slow time constant (26, 40) are reduced, and/or
- in case said second amplifier's output signal (4) exceeds a predefined threshold, the gain of the second amplifier is reduced.

8. Gain control unit according to any one of the preceding claims,
**characterized by**
- a first control loop (34) for generating said first gain control signal (29) and
- a second control loop (35) for generating said second gain control signal (45).

9. Gain control unit according to claim 8,
**characterized in that**
said first control loop (34) comprises a first subtracter (23) for determining a first difference (24) between said first amplifier's output signal (18) or a signal derived therefrom, and a first reference value (22).

10. Gain control unit according to claim 8 or 9,
**characterized in that**
said first control loop (34) comprises
- a first scaling unit (25) for scaling said first difference (24) in accordance with said fast time constant (26), in order to obtain a first scaled difference (27) and
- a first integrator (28) for deriving said first gain control signal (29) from said first scaled difference (27).

11. Gain control unit according to any one of the claims 8 to 10,
**characterized in that**
said second control loop (35) comprises a second subtracter (36) for determining a second difference (38) between said first gain control signal (29) and a second reference value (37).

12. Gain control unit according to any one of the claims 8 to 11,
**characterized in that**
said second control loop (35) comprises
- a second scaling unit (39) for scaling said second difference (38) in accordance with said slow time constant (40), in order to obtain a second scaled difference (41) and
- a second integrator (42) for deriving said second gain control signal (45) from said second scaled difference (41).

13. Gain control unit according to claim 11 or 12,
**characterized in that**
said medium range of gain values is defined by said second reference value (37).

14. Gain control unit according to claim 10 or 12,
**characterized in that**
at least one of said first integrator (28) and said second integrator (42) comprises a register (31, 44) for storing a former gain control value and an adder (30, 43).

15. Receiver adapted for receiving an RF signal (2),
comprising:
- a RF amplifier (3) for amplifying said RF signal (2),
- a downconversion unit (5) for converting an amplified RF signal (4), or a signal derived therefrom, into an IF signal (6),
- an IF amplifier (9) for amplifying said IF signal (6), and
- a gain control unit (13) according to anyone of claims 1 to 14, whereby said RF amplifier's gain in controlled by said second gain control signal (45), and whereby said IF amplifier's gain is controlled by said first gain control signal (29).

16. Receiver according to claim 15,
**characterized by**
an A/D converter (19) for converting the IF amplifier's output signal (18), or a signal derived therefrom, into a digital signal.

17. Receiver according to claim 15 or claim 16,
**characterized by**
D/A converters (32, 46) for converting said first gain control signal (29) and said second gain control signal (45) into analogue gain control signals (33, 47).

18. Method for controlling a receiver's gain,
said receiver comprising at least a first amplifier (9) and a second amplifier (3),
**characterized by**
- a step of varying said first amplifier's gain in accordance with a comparable fast or low time constant (26) and by
- a step of varying said second amplifier's gain in accordance with a comparable slow or high time constant (40).

19. Method according to claim 18,
**characterized in that**
said first amplifier's input signal (8) is derived from said second amplifier's output signal (4).

20. Method according to claim 18 or 19,
**characterized by**
a step of varying said second amplifier's gain in a way that said first amplifier's gain is moved/driven towards a medium range of gain values.

21. Method according to any one of the claims 18 to 20,
**characterized by**
a step of deriving said first gain control signal (29) from the first amplifier's output signal (18) and a first reference value (22).

22. Method according to any one of the claims 18 to 21,
**characterized by**
a step of deriving said second gain control signal (45) from said first gain control signal (29) and a second reference value (37).

23. Method according to any one of the claims 18 to 22,
**characterized by**
- a step of reducing either said fast time constant (26), or said slow time constant (40), or both said fast and said slow time constant (26, 40) in case said first amplifier's output signal (18), or a signal derived therefrom, exceeds a predefined threshold and/or
- a step of reducing the gain of the second amplifier in case said second amplifier's output signal (4) exceeds a predefined threshold..

24. Method according to any one of the claims 18 to 23,
**characterized by**
a step of converting the first amplifier's output signal (18), or a signal derived therefrom, into a digital signal.

25. Method according to any one of the claims 18 to 24,
**characterized by**
a step of converting at least one of said first gain control signal (29) and said second gain control signal (45) into analogue gain control signals (33, 47).

26. Computer program product,
comprising computer program means adapted to embody the features of the gain control unit as defined in anyone of claims 1 to 14 when said computer program product is executed on a computer, digital signal processor or the like.

27. Computer program product, comprising computer program means adapted to perform the method steps as defined in anyone of claims 18 to 25 when said computer program product is executed on a computer, digital signal processor, or the like.
